(19)

Europäisches
Patentamt

European
Patent Office

Office européen
des brevets

(11) EP 2 387 039 A1

(12) EUROPEAN PATENT APPLICATION

(43) Date of publication:
16.11.2011 Bulletin 2011/46

(51) Int Cl.:
G11C 11/419 (2006.01)      G11C 7/18 (2006.01)
G11C 7/12 (2006.01)

(21) Application number: 11165741.7

(22) Date of filing: 11.05.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 12.05.2010 US 334116 P

(71) Applicants:
• Stichting IMEC Nederland
  5656 AE Eindhoven (NL)
• IMEC
  3001 Leuven (BE)
• Katholieke Universiteit Leuven, K.U. Leuven R&D
  3000 Leuven (BE)
(72) Inventors:
• Sharma, Vibhu
  3001 Leuven (BE)
• Cosemans, Stefan
  2400 Mol (BE)
• Dehaene, Wim
  3010 Kessel-Lo (BE)
• Catthoor, Francky
  9140 Temse (BE)
• Ashouei, Maryam
  5611 HX Eindhoven (NL)
• Huisken, Jos
  5583 GV Waalre (NL)

(74) Representative: Sarlet, Steven Renaat Irène et al
Gevers Patents
Holidaystraat 5
1831 Diegem (BE)

(54) Hierarchical buffered segmented bit-lines based sram

(57) A semiconductor memory device (1) comprising: a plurality of memory blocks (2) with memory cells (3) connected to a local bit-line (4a, 4b), each local bit-line being connectable to a global bit-line (5) for memory readout; pre-charging circuitry (24, 25, 26) for pre-charging the bit-lines; and a read buffer (17) for discharging the global bit-line during a read operation. The local bit-lines are pre-charged to a predetermined first voltage substantially lower than the supply voltage (VDD) of the memory device. A segment buffer (16) is provided between each local bit-line and an input node (18) of the respective read buffer. The segment buffer activates the read buffer (17) during the read operation upon occurrence of a discharge on the connected local bit-line.

Fig. 6

**Description**

**TECHNICAL FIELD**

The present invention relates to a semiconductor memory device comprising a plurality of memory blocks, each memory block comprising a plurality of memory cells connected to a local bit-line, each local bit-line being connected to a global bit-line for memory readout. More in particular the invention relates to a static random access memory device.

**BACKGROUND ART**

Static random access memory (SRAM) devices are known in the art. The usage of SRAM is continuously increasing in system-on-chip (SOC) designs. According to the International Technical Roadmap for Semiconductors (ITRS) predictions, memory area is becoming larger and will occupy more and more area of a system-on-chip design. Process technology scaling has contributed remarkably in improving the performance and area density of system-on-chip, whereby the high density SRAM cell typically utilizes the minimum sized transistors. However, SRAM scaling has become extremely difficult in the advanced sub-nanometric CMOS technology nodes, partly because the bit-line capacitances do not scale by the same factor as the SRAM cell current.

SRAM arrays are typically used as a L1 cache, fastest cache in memory hierarchy.. SRAM storage cells are typically designed for very high density. The transistor sizes of the SRAM cell are kept minimum sized in order to achieve high density targets.

For example, US 5,668,761 discloses a high performance domino SRAM including multiple local cell groups, each cell group including multiple SRAM cells and local true and complement bit-lines LBLT and LBLC. Each SRAM cell includes a pair of inverters that operate together in a loop to store true and complement (T and C) data. The local true bit-line LBLT and the local complement bit-line LBLC are connected to each SRAM cell by a word line N-channel field effect transistor (NFETs) to respective true and complement sides of the inverters. A WORDLINE provides the gate input to word line NFETs. A particular WORDLINE is activated, turning on respective word line NFETs to perform a read or write operation. Associated with each local cell group are precharge true and complement circuits coupled to the respective local true and complement bit-lines LBLT and LBLC, write true and write complement circuits, and a local evaluate circuit. Each of the local evaluate circuits is coupled to a global bit-line and a second stage inverter that provides output data or is coupled to more stages. A read occurs when a word line is activated. Since true and complement (T and C) data is stored in the SRAM memory cell, either the pre-charged high true local bit-line LBLT will be discharged if a "zero" was stored on the true side, or the pre-charged high complement bit-line LBLC will be discharged if a "zero" was stored on the complement side. The local bit-line, LBLT or LBLC connected to the "one" side will remain in its high pre charged state. If the true local bit-line LBLT was discharged then the "zero" will propagate through one or more series of domino stages eventually to the output of the SRAM array. If the true local bit-line was not discharged then no switching through the domino stages will occur and the pre-charged value will remain at the SRAM output.

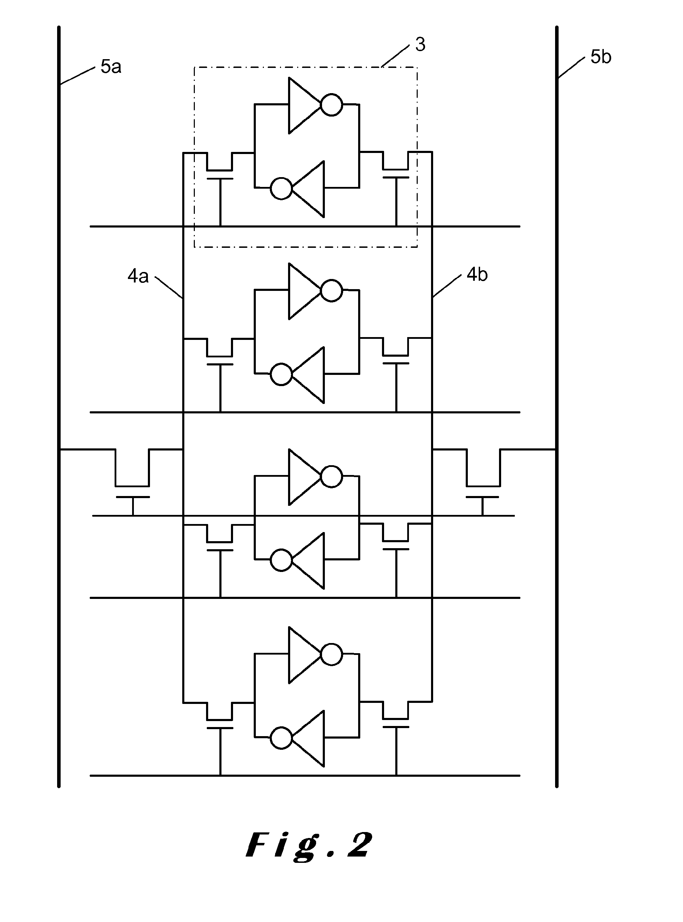

In ref [4] and illustrated in Fig 2, A.Karandikar and K.K.Parhi describe a "Low power SRAM design using hierarchical divided bit-line approach" for reducing active power in SRAMs by reducing bit-line capacitance. Two or more SRAM cells are combined together to divide the bit-line into several sub bit-lines. These sub bit-lines are again combined to form two or more levels of hierarchy. This division of bit-lines into hierarchical sub bit-lines results in reduction of bit-line capacitance which reduces active power and access time.

There is however a constant desire to provide a static random access memory (SRAM) with a faster access time that consumes less power.

**DISCLOSURE OF THE INVENTION**

It is an aim of the present invention to provide a semiconductor memory device with a reduced active power and a reduced read access time.

This aim is achieved according to the present invention with a semiconductor memory device having the characteristics of the first claim. Thereto the present invention provides a semiconductor memory device comprising:

- a plurality of memory blocks, each memory block comprising a plurality of memory cells connected to a local bit-line via at least one switch per memory cell, each local bit-line being connectable to a global bit-line for memory readout;
- pre-charging circuitry for pre-charging the local and global bit-lines during an idle state;
- at least one read buffer connected between at least one of the local bit-lines and the global bit-line and being provided for discharging the pre-charged global bit-line during a read operation upon occurrence of a discharge of one of the pre-charged local bit-lines connected thereto.

The device according to the invention is characterised in that the pre-charging circuitry comprises a first pre-charging circuit for pre-charging the local bit-line to a predetermined first voltage during said idle state, said predetermined first voltage being substantially lower than the supply voltage of the memory device; and in that a segment buffer is provided between each local bit-line and an input node of the respective read buffer, the segment buffer being provided for activating said read buffer during said read operation upon occurrence of said discharge on the respective bit-line.

By pre-charging the local bit-lines to a voltage substantially lower than the supply voltage, VDDlow (e.g. VDD/2), the active power dissipation due to charging and discharging of the local bit-lines when accessing memory cells, can be reduced.

The insertion of a segment buffer between the local bit-line and the read buffer can accelerate the discharge process. A sufficient voltage drop at the input node of the read buffer for reliably reading the value of the memory cell can be achieved even though the local bit-lines are pre-charged with a voltage substantially lower than the supply voltage. The segment buffer thus allows for a decoupling of the local bit-line from the read buffer, allowing a reduced voltage swing on the local bit-lines. In this way energy consumption can be reduced, while still reliably driving the read buffer.

Another advantage of the reduced first voltage (as compared to pre-charging to VDD) is that less time is needed for charging and discharging the local bit-line to a sufficient level for activating the read buffer, which results in reduced memory access latency.

In a preferred embodiment, the predetermined first voltage is above a predetermined minimum and the segment buffer is adapted to not activate the read buffer during said read operation as long as the voltage on the respective bit-line is above said minimum. In this way, when a bit value is read at a memory cell by which no discharge of the pre-charged bit-line occurs, the read buffer is not activated even though the segment buffer is enabled. For example, in the case of an NMOS transistor as segment buffer (see preferred embodiments below), the value of the minimum predetermined voltage is such that the overdrive of the NMOS transistor when enabled remains below or at most, equal to 0. It will be appreciated that the same operation can be achieved with other components as segment buffer.

In a preferred embodiment the predetermined first voltage is substantially equal to 50% of the supply voltage. By reducing the voltage swing of the local bit-lines to VDD/2 instead of VDD, the active power consumption due to charging and discharging the local bit-lines can be reduced up to a factor of four.

In a preferred embodiment the pre-charging circuitry further comprises a second pre-charging circuit for pre-charging the input node of the read buffer to a second voltage above the first voltage and the segment buffer is adapted for causing a voltage drop on said input node to activate the read buffer. In this way the input node of the read buffer can be at a second voltage sufficiently high (e.g. VDD) for reliably keeping the read buffer deactivated when the local bit-line is not discharged, and for allowing the input node of the read buffer to be discharged to a voltage low enough for activating the read buffer in case the local bit-line is discharged.

Preferably the second voltage is substantially equal to the supply voltage. By pre-charging the input of the read buffer to VDD instead of to some intermediate voltage level (e.g. 80% of VDD), the need for another supply voltage can be avoided.

In a preferred embodiment, the segment buffer is an NMOS transistor which is upsized with respect to the transistors used in the memory cells. Preferably, the segment buffer NMOS transistor is at least 50% larger, more preferably at least 100% larger that the transistors used in the memory cells. For the memory cells typically the lowest size transistors allowed by the technology are used to achieve the maximum density (smallest area), resulting in a limited current for discharging the local bit-lines. By using a larger transistor for the segment buffer, a larger current for discharging the input node of the read buffer is provided, thereby accelerating the voltage drop at the input node. This higher current can further reduce the read access time of the memory cell, at the expense of a small area increase.

In a preferred embodiment the read-out circuit comprises a global access buffer driven by an inverter. However, other logic circuits can also be used.

Preferably the global access transistor is an NMOS transistor which is upsized with respect to the transistors used in the memory cells. Preferably, the global access NMOS transistor is at least 50% larger, more preferably at least 100% larger that the transistors used in the memory cells. By choosing an upsized global access NMOS transistor with respect to the minimum size allowed by the technology, the SRAM access time can be further decreased, by an accelerated discharge of the global bit-line, at the expense of a small area increase.

Preferably the input node of the read buffer is connected to at least two memory blocks, each having a corresponding segment buffer. In this way one read buffer is shared between two or more memory blocks and chip area can be saved.

The invention is applicable to SRAM memories and is described herein in detail for such memories. However, the invention can also be applied in any other volatile memories.

The invention further relates to an electrical device comprising such an SRAM or other memory device, for example any battery powered hand-held device, in particular mobile phones, game consoles, PDA's etc.

## BRIEF DESCRIPTION OF THE DRAWINGS

The invention will be further elucidated by means of the following detailed description of preferred embodiments and the appended drawings.

Fig 1 shows a read operation in a traditional SRAM architecture without a bit-line hierarchy

Fig 2 shows an example of a hierarchical divided bit-line architecture known in the art.

Fig 3 shows plot of the access time versus supply voltage for HVT (high threshold voltage) minimum sized SRAM cells in different technology nodes, for a memory of 512 x 512 cells, whereby TAccess is the delay between the word line activation and 100mV voltage drop on the bit-lines.

Fig 4A shows a plot of the access time, and Fig 4B shows a plot of energy versus the number of cells in the local hierarchy for hierarchical divided bit-line architecture and a memory size of 512 x 512 cells.

Fig 5 shows an example of hierarchical divided bit-line (HDBL) architecture, known in the art, using NAND-gates.

Fig 6 shows a preferred embodiment of a hierarchical buffered segmented bit-line based SRAM architecture, according to the present invention.

Fig 7 shows part of the architecture of Fig 6 in more detail. It shows a circuit diagram with "8T SRAM" cells.

Fig 8 shows an example of a timing-diagram for a read access operation for the circuit in Fig 7.

Fig 9 shows a plot of access time versus supply voltage of a memory device of 512 x 512 cells, for different architectures implemented in 65nm Low Power Technology.

Fig 10 shows a plot comparing the access time of a HBS-architecture based SRAM according to the present invention versus a traditional SRAM design (no hierarchy) for different values of power supply in 65nm Low Power Technology.

Fig 11 shows a graph comparing the access energy per bit versus supply voltage for a memory size of 512 x 512 cells in 65nm Low Power Technology for different architectures.

Figures 12A-12C shows the detailed working of the circuit of Fig 7 when reading a logical "0" from the memory-cell.

Figures 13A-13C shows the detailed working of the circuit of Fig 7 when reading a logical "1" from the memory-cell.

## DETAILED DESCRIPTION OF PREFERRED EMBODIMENTS

### REFERENCE NUMBERS

[0024]

1    memory device

2    local memory block = segment

3    memory cell

4    local bit-line

5    global bit-line

16    segment buffer

17    read buffer

18    input node of read buffer

19    global access transistor

20    inverter

21    sense amplifier

22    first pass transistor

23    second pass transistor

24      transistor for pre-charging the input node of read buffer

25      transistor for pre-charging the local bit-line

26      transistor for pre-charging the global bit-line

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting of only components A and B. It means that with respect to the present invention, the only relevant components of the device are A and B.

The present invention relates to static random access memory (SRAM) devices. In particular, the present invention discloses an improved SRAM architecture and method for reading the memory cells with a reduced active power consumption and a reduced access time.

In the past, process technology scaling has contributed remarkably in improving the performance of and area density of system-on-chip (SoC) in general, and SRAM in particular. But the SRAM scaling has become extremely difficult in the advanced technology nodes (e.g. 32 nm LP CMOS, and beyond). This is mainly because of the fact that, in order to realize the high density, the SRAM cell utilizes the minimum sized transistor which is susceptible to Vt (threshold voltage) mismatches. The Vt mismatch is mainly caused by a dopant-ion implantation variation and gate edge roughness and is inversely proportional to the transistor size, as described in ref [1].

In order to better appreciate the present invention, first a traditional SRAM architecture (without a bit-line hierarchy) is described, then the hierarchical divided bit-line architecture (HDBL), which is an improvement thereof, and then the Hierarchical Buffered Segmented bit-line architecture (HBS) according to the present invention. The access time (or delay time) and the access energy are compared.

TRADITIONAL SRAM DESIGN (NO HIERARCHY):

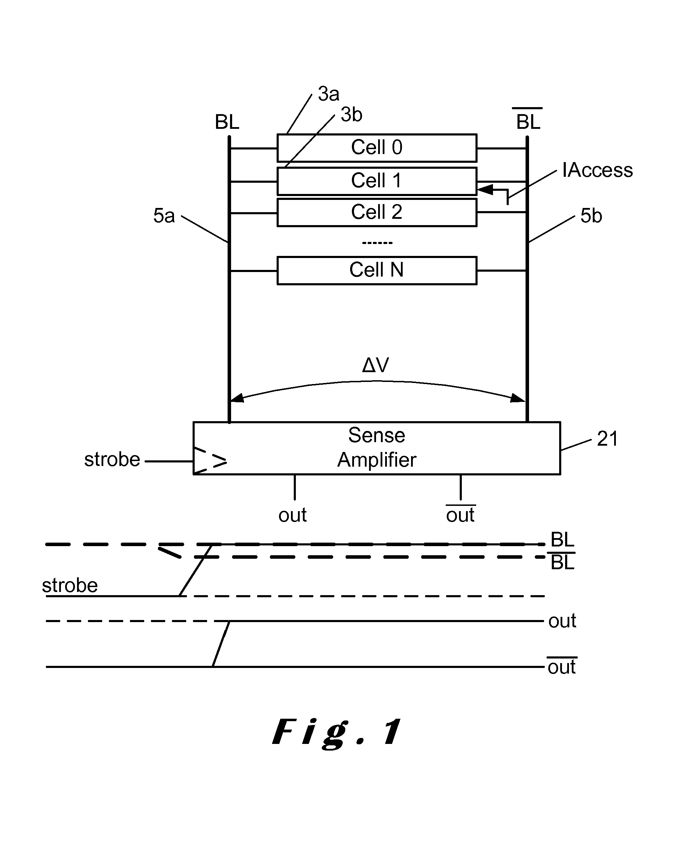

Fig 1 shows a traditional SRAM architecture without a bit-line hierarchy, further called No-Hierarchy, abbreviated as NH-architecture. An asserted SRAM cell 3b during READ operation has to discharge a huge capacitive pre-charged read bit-line BL. The asserted SRAM cell 3b starts to discharge the pre-charged BL to a voltage difference that is larger than the offset mismatch voltage of the sense amplifier (SA) 21. Fig 1 illustrates how an asserted memory cell 3b has to discharge one of the bit-lines BL or BL\, depending on the value stored in the memory cell being a logic "0" or logic "1 ". Further in this application, abstraction is made of the True and Complement bit-lines, unless explicitly mentioned otherwise.

The following formulae are applicable to this NH-architecture:

$$TAccess = QBL\ /\ IAccess \qquad (1)$$

$$QBL = CBL\ .\ \Delta Vmin \qquad (2)$$

$$CBL = N \times Cdcell + Cwire \qquad (3)$$

$$EAccess = CBL \times VDD \times \Delta Vmin \qquad (4)$$

whereby:

TAccess is the access time for reading the memory cell,
IAccess is the SRAM cell read current,
CBL is the capacitance of the read bit-line (BL or BL\)
QBL is the charge stored on CBL,
Cdcell is the drain capacitance of one SRAM cell,
Cwire is the wiring capacitance of the bit-lines,
$\Delta Vmin$ is the minimum voltage difference that the sense amplifier 21 can reliably resolve,
N is the number of cells on the read bit-line,
VDD is the supply voltage,
EAccess is the active energy required for reading the memory cell.

The impact of SRAM cell variations on EAccess and TAccess is getting more pronounced in sub nanometric technologies (e.g. technology node 32 nm LP CMOS, and beyond). The IAccess varies widely as the transistors are kept as small as possible to achieve the high area density targets. The cell current IAccess is reduced by the transistor scaling. The low power requirement further aggravates the situation, to limit the standby leakage the cells are implemented in HVT (high threshold voltage) transistors. This not only reduces the cell read current IAccess but also the impact of variation becomes more severe. The target applications will require faster access time (smaller TAccess) compared to the previous technology generation. The bit-line capacitances are not getting reduced by the same factor as the IAccess values. This results in a performance loss, as illustrated in Fig 2, showing that the TAccess in predictive 32 nm traditional architecture will be more than TAccess in 90nm at 0.8V.

Another problem associated is the increase in EAccess due to intra-die variation. The asserted cell 3b stops discharging the bit-line (e.g. BL) only when the word line (not shown) is deactivated. With the result that the average bit-line voltage swing $\Delta V$ is always larger than $\Delta Vmin$ required by the sense- amplifier 21. In order to achieve correct operation under all process corners, design margins are taken for the word-line activation. Unfortunately, due to increased intra-die variation in sub-nanometric technologies replica based techniques as proposed in ref [2] without increasing the design margins are no longer effective to insure the correct functionality.

Due to the impact of large intra-die variations in sub-nanometric technologies, different cells 3 of the accessed word on the same die generates different voltage swings $\Delta V$ with the same word-line activation duration. For reliable operation, the voltage swing $\Delta V$ developed by the slowest cell 3 has to be larger than the $\Delta Vmin$ requirement set by the offset mismatches of the sense amplifier 21. With the result that the average voltage swing of the cells 3 in an accessed word becomes larger than this minimum value $\Delta Vmin$, thereby increasing the average energy consumption EAccess associated with pre-charging the high capacitive bit-lines, as described in ref [3].

HIERARCHICAL DIVIDED BIT-LINE:

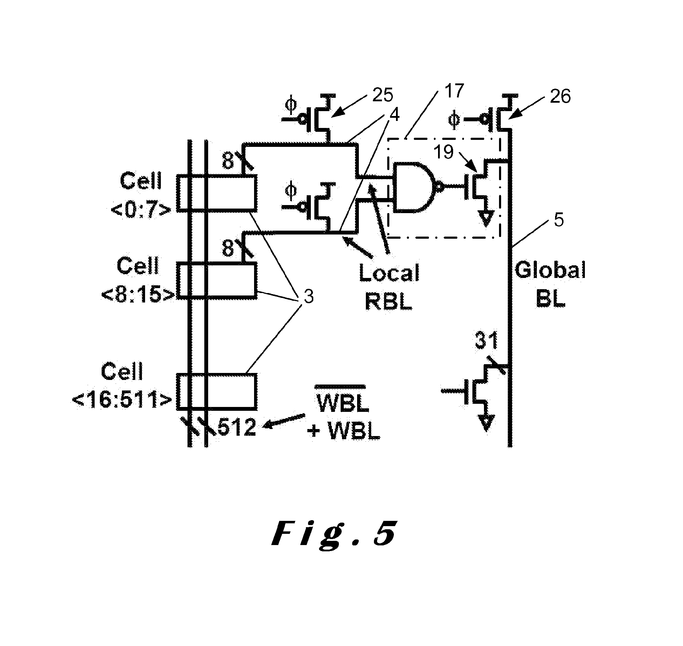

In the hierarchical divided Bit-line approach, illustrated in Fig 2 and Fig 5, and in this document further abbreviated as HDBL, the idea is to increase the discharge speed of the bit-line without upsizing the SRAM cell 3, by reducing the capacitance to be discharged by a SRAM cell 3. In the HDBL-architecture this is done by replacing a large capacitive bit-line by a short local bit-line 4 that connects through a pass transistor to a global bit-line 5. In high performance memories [ref 5, ref 6] the read bit-line is divided in short full swing bit-lines connecting 8 to 16 cells. It uses full swing signals on the local and global bit-lines 4, 5. The short local bit-line 4 is discharged when the cell storing "0" is asserted. The voltage drop created by an accessed SRAM cell on the short local bit-line is used to trigger the read buffer 17. Then the global access transistor 19 is turned ON and creates a large access current thereby discharging high capacitive read bit-line. Ref [5] uses a sense amplifier 21 in a local hierarchy, which is shared with multiple columns in order to minimize the area penalty. Whereas ref [6], illustrated in Fig 5, uses a NAND gate based read buffer shared between 2 columns.

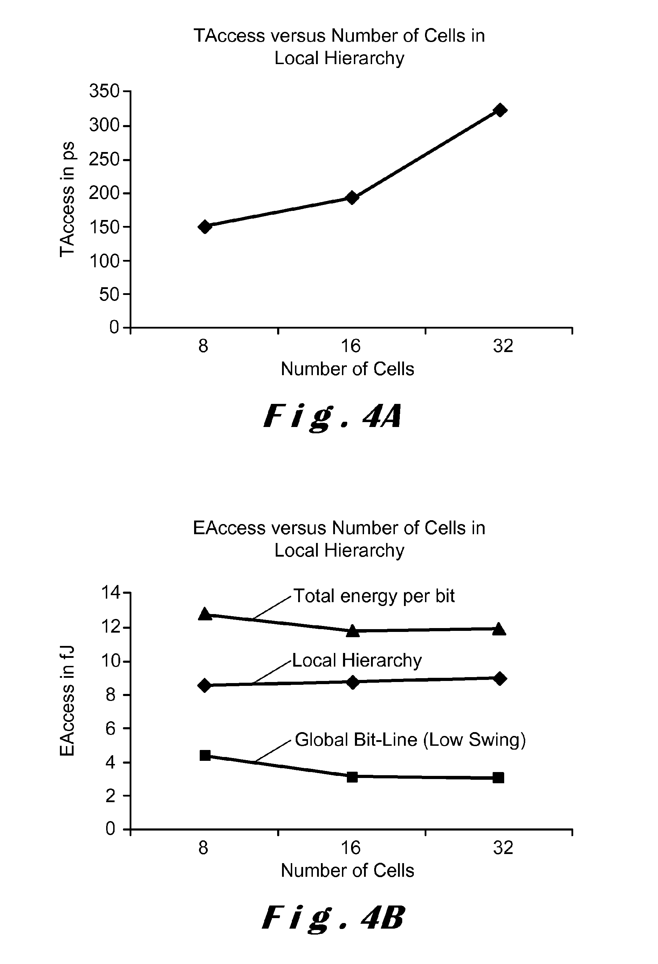

Fig 4A show a plot of the access time (in ps), and Fig 4B shows a plot of energy (in fJ) versus the number of cells in the local hierarchy for a memory size of 512 x 512 cells in the HDBL architecture for 8, 16 or 32 cells (in 65 nm LP technology).

The following formulae are applicable to this architecture:

$$Tdelay\ (HDBL) = Tdlocal\_rbl1 + TdGrbl \qquad (5)$$

$$= Qlocal\_rbl1/ICell,read + QGrbl/Iaccess$$

$$= NL.Clocal\_rbl1.Vswing/ICell,read + CGrbl.\ \Delta Vmin\ /Iaccess$$

$$EAccess\ (HDBL) = Elocal\_rbl1 \qquad (6)$$

$$= NL.Clocal\_rbl1.(VDD)^2$$

whereby:

Tdelay is the access time for reading a memory cell,
Tdlocal_rbl1 is the time delay for accessing the local read-bit-line,
TdGrbl is the time delay for discharging the global bit-line,
Clocal_rbl1 is the capacitance of local read bit-line per cell,
Olocal_rbl1 is the charge stored on Clocal_rbl1,
CGrbl is the capacitance of the global read bit-line,
QGrbl is the charge stored on CGrbl,
ICell,read is the SRAM cell read current,
Vswing is the minimum voltage swing required on the local bit-line for toggling of the read buffer,
Iaccess is the drain current of the global access transistors,
$\Delta$Vmin is the minimum voltage difference to be resolved by the sense amplifiers,
EAccess is the active energy per access per bit,
NL is the number of cells in the local hierarchy.

In an example (in 65 nm low power technology) the memory size is 512 x 512 cells, NL = 16, VDD = 0.7V = Vswing, ICell,read = 30$\mu$A, Clocal_rbl1 = 0,25fF, IAccess = 180$\mu$A, $\Delta$Vmin = 100mV, CGrbl = 120fF, resulting in access speed Tdelay = 160 ps & Eaccess(HDBL) = 1.96fJ/bit

The access time Tdelay in the HDBL architecture, (being 160 ps) is definitely improved as compared to the traditional NH-approach (being 504ps for the same column height of 512 cells). It is still limited however by the fact that the minimum sized accessed SRAM cell has to discharge the local bit-line to a voltage that is low enough in-order to reliably trigger the read buffer 17. Another disadvantage is that the energy associated with pre-charging full-swing local bit-lines is also high. Therefore, a solution is desired which can further improve the access speed and also reduces the access energy.

EMBODIMENT OF THE PRESENT INVENTION

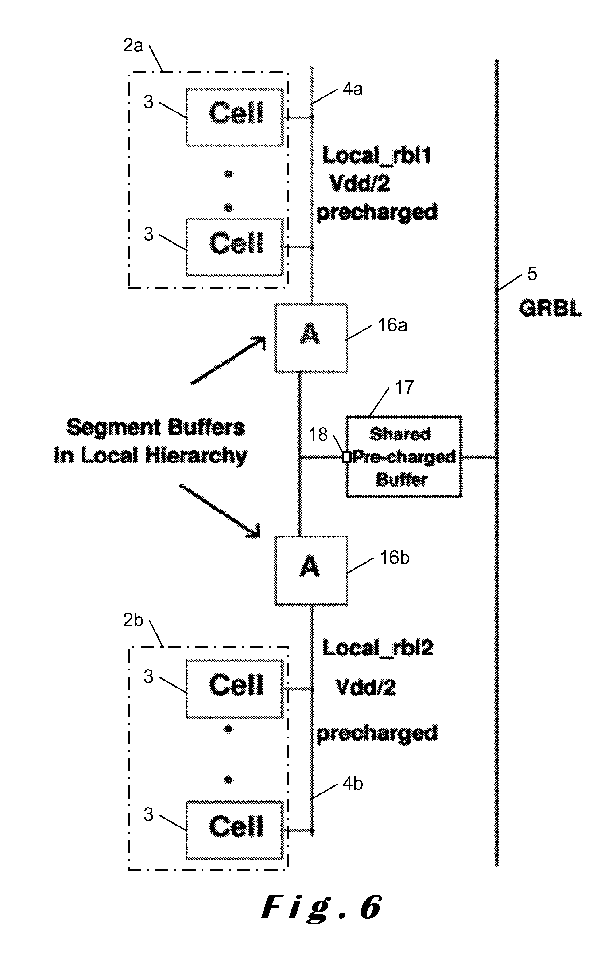

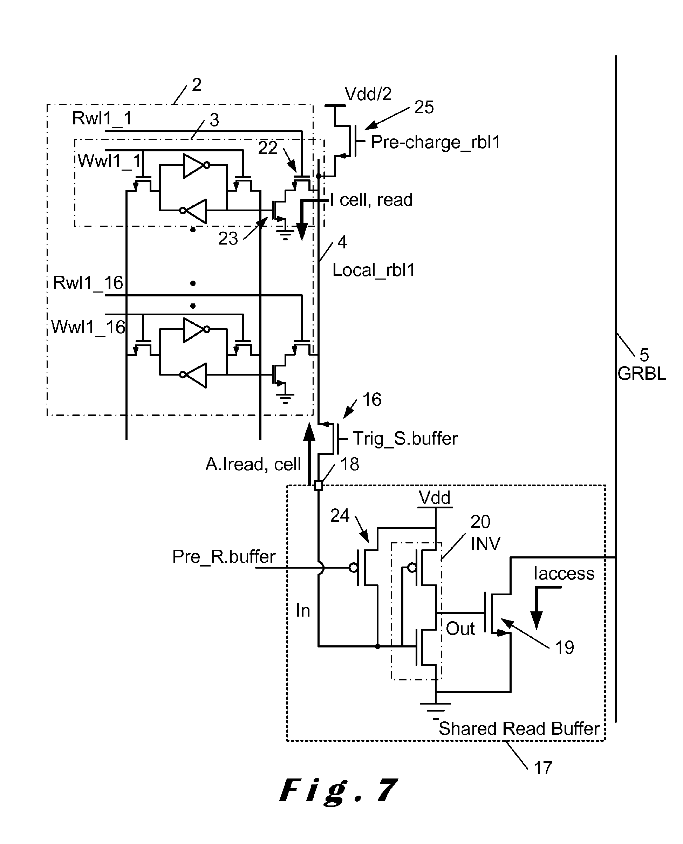

Fig 6 schematically illustrates the SRAM architecture disclosed by the present invention, called the Hierarchical Buffered Segmented bit-line architecture, in this document further abbreviated as HBS-architecture. In this architecture, segmentation of the local bit-lines 4 is done and segment buffers 16 are added to each local hierarchy 2. Thanks to this segmentation, the local bit-line 4 connected to the SRAM cells 3 is pre-charged to a voltage level VDDlow which is substantially lower than VDD, e.g. VDD/2, thereby reducing the active power consumption associated with pre-charging and discharging the local bit-lines 4. As shown in Fig 7, the read buffer 17 (electronic read circuit) preferably consists of a global access transistor 19 driven by an inverter 20 having an input node 18, which is held at logic "high" when not used by pre-charging it to a high voltage, e.g. VDD. In order to limit the number of pre-charged read buffers 17, each one is preferably shared with 2 or more local memory blocks 2, meaning that the input 18 of the inverter 20 is preferably connected to two or more segment buffers 16. The pre-charged read buffer 17 is driven by the segment buffer 16 of an activated local memory block 2. The use of the segment buffer 16 improves the performance as compared to the HDBL-architecture, where a full VDD voltage swing is applied to the local bit-lines 4, and wherein the asserted minimum sized accessed SRAM cell 3 drives the read buffer 17.

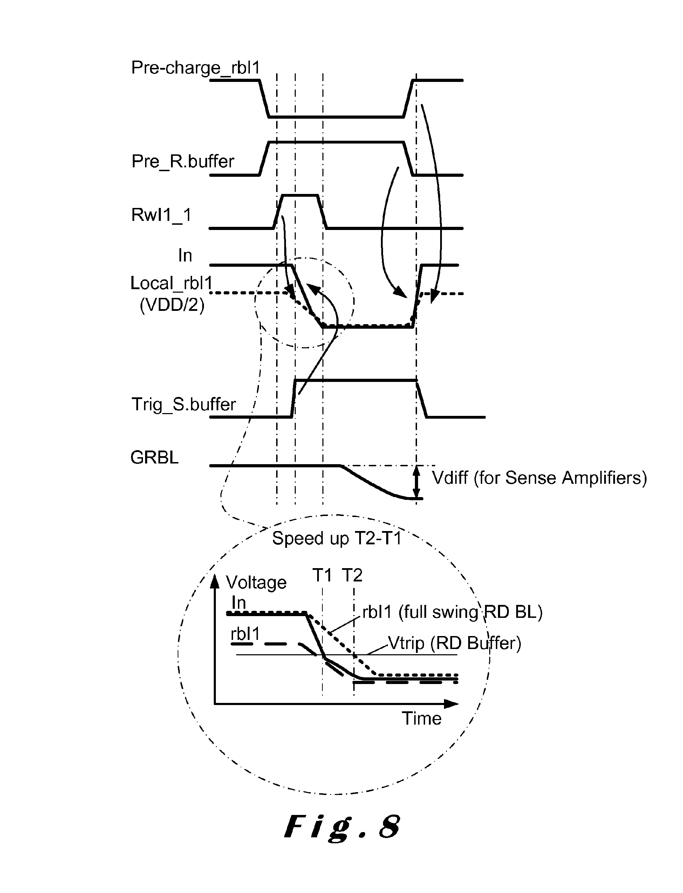

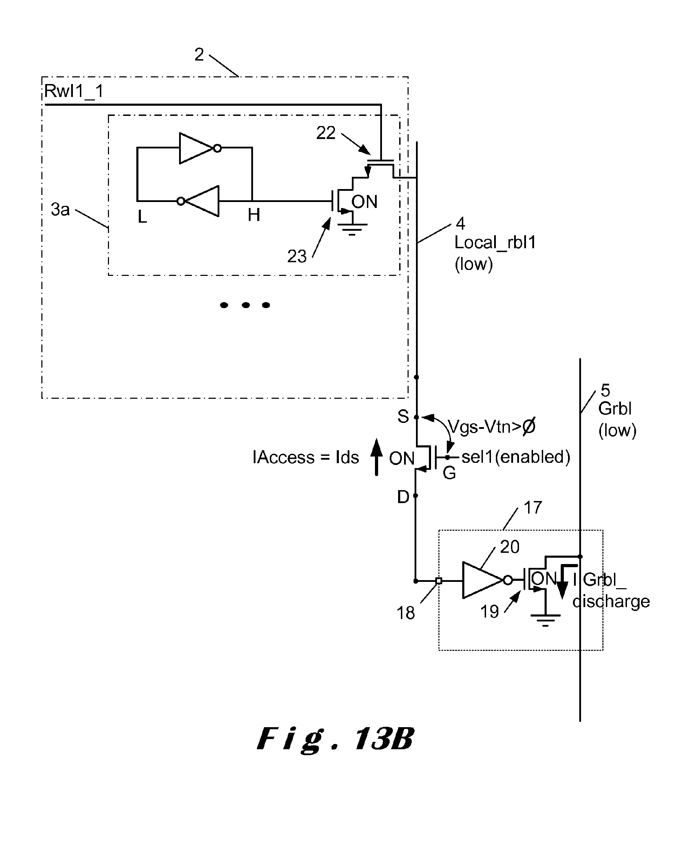

In contrast, in the HBS-architecture according to the present invention, ICell,read created by an accessed SRAM cell 3 is amplified by the NMOS transistor 16 acting as a segment buffer 16, as illustrated in Fig 7. In an embodiment the size of the NMOS transistor 16 is 2x the size of the transistors used in the SRAM cells 3. As this segment buffer 16 is shared with the plurality of SRAM cells 3 in the local hierarchy 2, e.g. eight (8) or sixteen (16) cells, the area penalty associated with this larger NMOS transistor 16 is limited. The toggling of the read buffer 17 depends on the rate of discharge of the input node 18 of the inverter 20. In the HDBL architecture, the input node 18 of the read buffer circuit 17 is discharged by the ICell,read of the memory cells 3 directly. Whereas, with the use of segment buffer 16 the input-node 18 of the read buffer 17 in the HBS-architecture is discharged by A x ICell,read, "A" being an amplifier factor larger than 1 (e.g. 3), which results in faster toggling of the read buffer 17, as illustrated in the timing diagram of Fig 8, which will be explained further, when describing Fig 13B.

The following formulae are applicable to the HBS-architecture:

$$\text{Tdelay (HBS)} \cong \text{Tdlocal\_rbl1} + \text{TdGrbl} \qquad\qquad (7)$$

$$\cong \text{Qlocal\_rbl1/ICell,read} + \text{QGrbl/IAccess}$$

$$\cong \text{NL.Clocal\_rbl1.Vswing/(A.ICell,read)} + \text{CGrbl. } \Delta\text{Vmin /IAccess}$$

$$\text{E Access (HBS)} = \text{Elocal\_rbl1} \qquad\qquad (8)$$

$$= \text{NL.Clocal\_rbl1.(VDDlow)}^2$$

whereby:

Tdelay is the access time of the memory cell,
Tdlocal_rbl1 is the time required to trigger the local read buffer.,
TdGrbl is the time required to discharge the global bit-line,
Qlocal_rbl1 is the charge stored on the local bit-line,
QGrbl is the charge stored on the global bit-line,
IAccess is the drain current of the global access transistor 19,
Clocal_rbl1 is the capacitance of local read bit-line per cell,
Vswing is the minimum voltage swing required on the local bit-line,
CGrbl is the capacitance of global read bit-line,
$\Delta$Vmin is the minimum voltage difference to be resolved by the sense amplifiers 21,
ICell,read is the SRAM cell read current,
A.ICell,read is the drain current of the segment buffer,
EAccess is the active energy per access per bit,
NL is the number of cells in the local hierarchy.

By comparing formulas (5) and (7), and taking into account that Vswing < VDD, and that A > 1, it is clear that:

$$\text{Tdelay (HBS)} < \text{Tdelay (HDBL)} \qquad\qquad (9)$$

By comparing formulas (6) and (8), and taking into account that Vswing < VDD, it is clear that:

$$\text{EAccess (HBS)} < \text{EAccess (HDBL)} \qquad\qquad (10)$$

In an example (in 65 nm LP technology) the memory size is 512 x 512 cells, NL = 16, VDD = 0.7V, Vswing = VDD/2 = 0,35V, A x ICell,read = 90$\mu$A, Clocal_rbl1 = 0,25fF, IAccess = 180$\mu$A, $\Delta$Vmin = 100mV, CGrbl = 120fF, resulting in access speed Tdelay = 82 ps and EAccess(HBS) =0,49 fJ/bit.

In implementation, the additional timing circuitry required for the segment buffers 16 and pre-charged read buffer 17 will increase the energy consumption by approximately 0.5 fJ/bit, so that the total access energy will be approximately EAccess = 0.99 fJ/bit for the HBS-architecture of the present invention (in 65 nm LP technology). This reduces the access energy EAccess by a factor of 2,0, and increases the access speed by a factor of 1,9 as compared to the HDBL architecture.

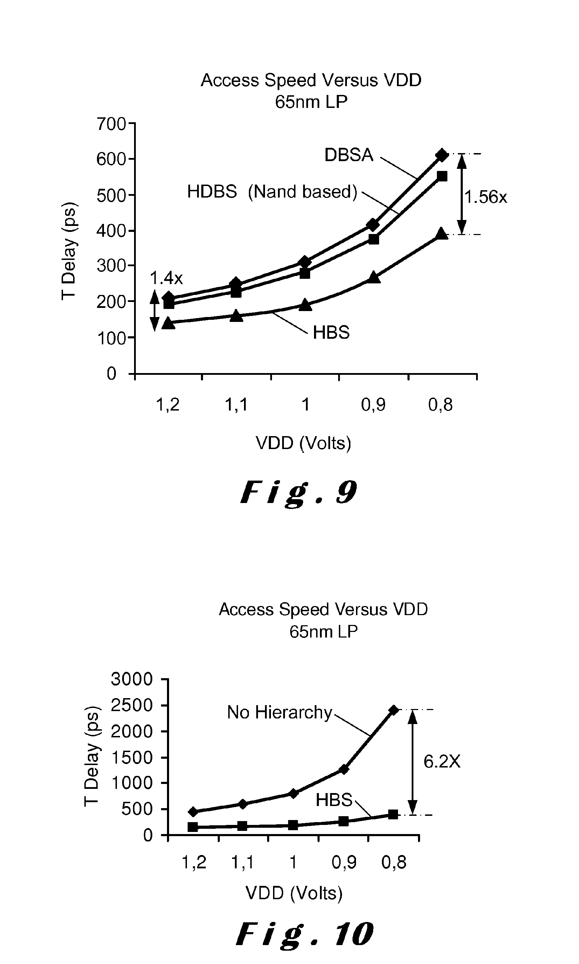

In Fig 9, the performance of the HBS-architecture of the present invention is compared with other state of the art architectures used in high performance memories in 65nm lower power (LP) technology. A memory size of 512 x 512 cells is taken as a test case for comparison. The number of cells 3 taken in each local hierarchy 2 is sixteen "16", in order to minimize the energy consumption (Figure 4B). The minimum sized transistors are used for the SRAM cells design. The transistor size for the read buffers 17 is 2,0 x Wmin, the size of the segment buffers 16 and the pre-charged read buffers 17 in the HBS-architecture is also taken 2,0 x Wmin. Tdelay is the delay time from the word-line (WL) activation to a voltage drop of 100 mV on the global bit-lines. Figures 4A and 4B show that the access time of an SRAM with 8 cells in the local hierarchy would be slightly faster, at the expense of a slight increase of the energy access.

The curves in Fig 9 show that the SRAM design using the HBS architecture according to the present invention is 1,4x faster as compared to the HDBL Hierarchical Divided full swing Bit-line architecture [5, 6] at VDD = 1,2V. In order to verify the HBS architecture compatibility for the systems using Dynamic Voltage Scaling, the performance is compared for different values of the power supply VDD. From the plots, it is clear that the HBS Architecture is faster than the architectures described in [5] and [6] for different values of VDD. For example, at VDD = 0,8V the SRAM in the HBS architecture is 1,56x faster than the SRAM of ref [5], called "DBSA" (divided read bit line scheme with a shared local amplifier).

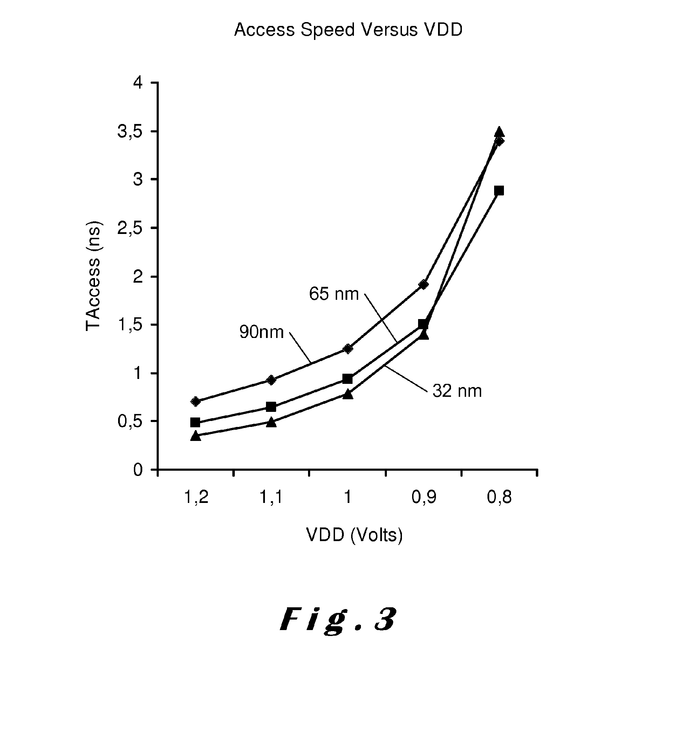

The memory cell current IAccess is considerably reduced in advance sub nano-metric technology nodes (e.g. 65 nm LP CMOS) due to the transistor scaling and the Vt random variations. With the result that the memory access time TAccess is severely impacted. As shown in Fig 3, for a memory size of 512 x 512 cells, the traditional SRAM design (no hierarchy) in 65nm at 0,8V is only 1,2x faster as compared to the SRAM design in 90nm. Fig 10 shows that the HBS architecture based SRAM design is 6,2x faster as compared to the conventional SRAM design in 65 nm. The HBS architecture based SRAM design in 65 nm is 7,4x faster as compared to the conventional SRAM design in 90 nm LP technology at 0,8V.

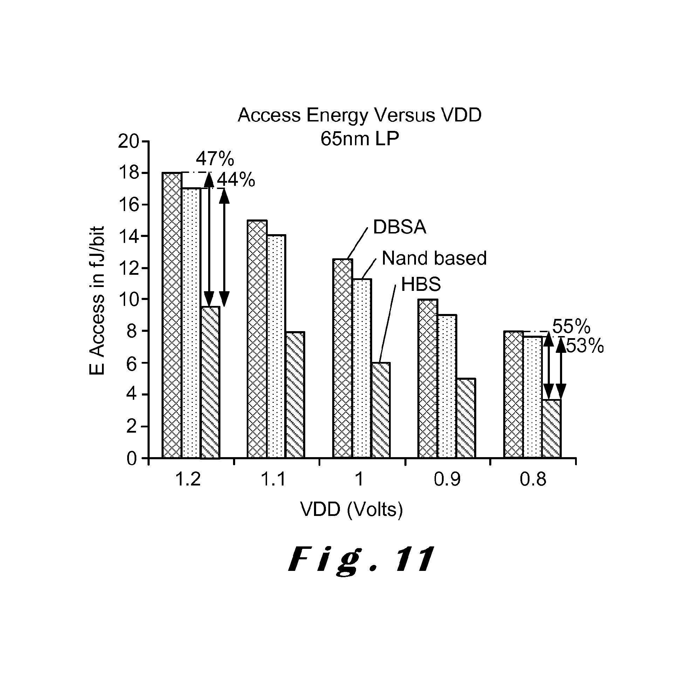

As shown in Fig 11, the HBS architecture based SRAM design according to the present invention reduces the energy consumption by 47% as compared to ref [5], and the energy reduction compared to ref [6] is 44% at VDD = 1,2 for 65nm LP Technology. The HBS architecture is not only faster at VDD = 0,8V (Fig 11) but also consumes (55 -53) % less energy as compared to the HDBL architecture based SRAM designs. The energy reduction with the HBS architecture is mainly due to the VDDlow (e.g. VDD/2) pre-charged local bit-lines 4. In the conventional HDBL approach [5, 6], the voltage drop on the local bit-lines 4 caused by the accessed SRAM cell 3 needs to trigger the read buffer 17. In that architecture it is not possible to trigger the read buffer 17 with the voltage drop created on VDDlow (e.g. VDD/2) pre-charged bit-lines 4, as it requires full swing signals as input. This is solved in the HBS architecture because not the memory cell 3, but the segment buffer 16 of the local hierarchy drives the pre-charged read buffer 17.

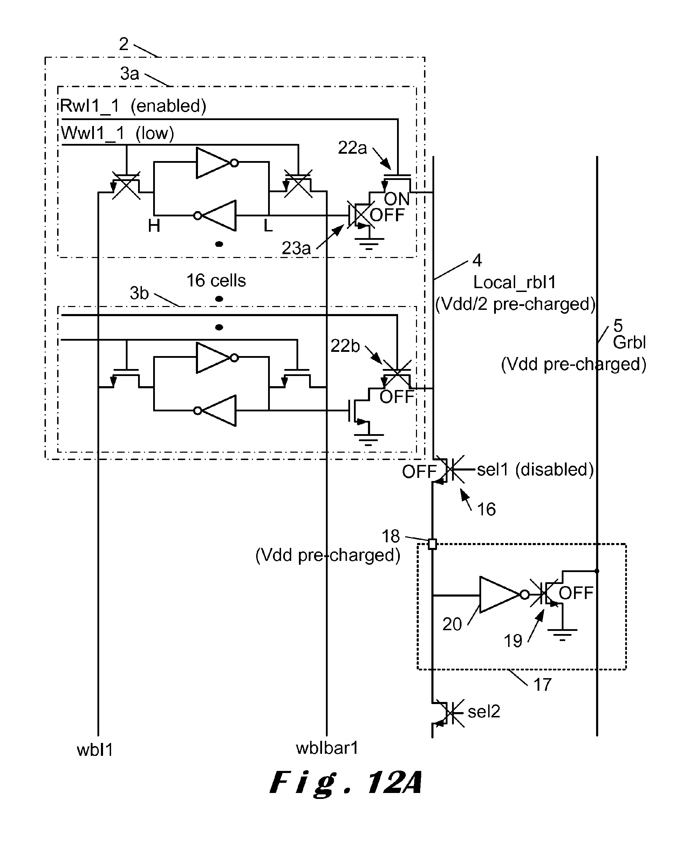

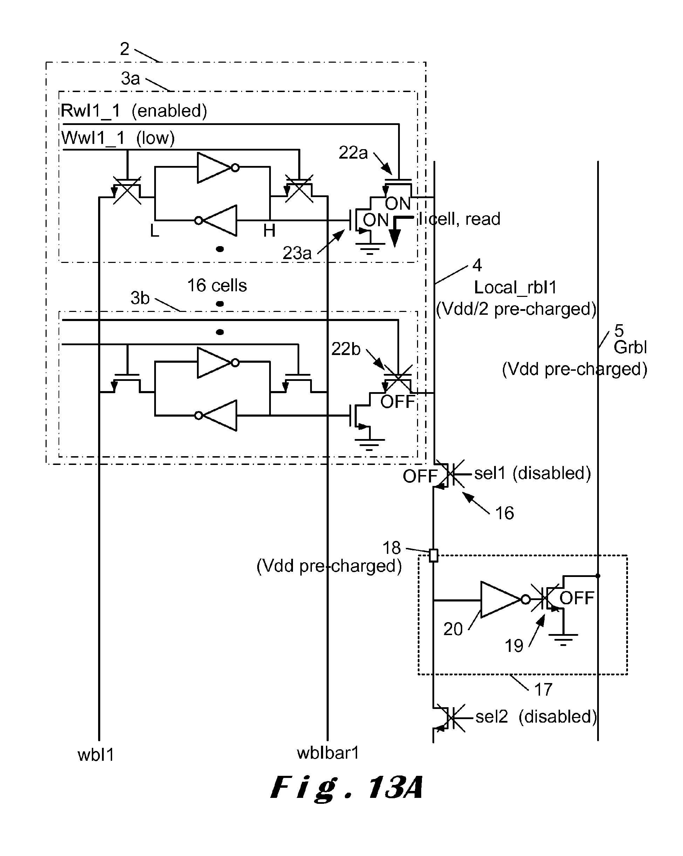

Figures 12A-12C show in detail how the circuit diagram of Fig 7 works for a read-operation of a logic "0" stored in the SRAM cell 3. Only one bit-line Local_rbl1 of the SRAM cell is drawn; the behaviour of the complementary stored value during the read-operation is illustrated in Figures 13A-13C, and vice versa.

In Fig 12A, a logic "Low" value is stored on one side (right) of the SRAM-cell 3, and a logic "High" value is stored on the other side (left) of the SRAM cell 3. The pass-transistor 23a is OFF because of the "Low" value stored in the SRAM cell 3. The write_word-line Wwl1_1 is held low during the entire read cycle. The segment buffer 16 is OFF by holding sel1 low. The global bit-line 5, Grbl is pre-charged to VDD, the local bit-line 4 is pre-charged to VDDlow (e.g. VDD/2), the input of the inverter 20 of the read-buffer 17 is pre-charged to VDD, thus the output of the inverter 20 is low and the global access transistor 19 is OFF.

For sensing the value stored in the SRAM cell 3, the read word-line Rwl1_1 is enabled (high), thus transistor 22 is turned ON. But in this case, since transistor 23 is OFF, no discharge path from the local bit-line 4 to the selected SRAM cell 3a exists. When reading SRAM cell 3a, the other SRAM cells 3b etc of this local memory block 2 are disabled, thus transistors 22b, etc are also OFF, and no discharge path for discharging the local bit-line 4 exists, thus its voltage remains the pre-charge voltage VDDlow (e.g. VDD/2).

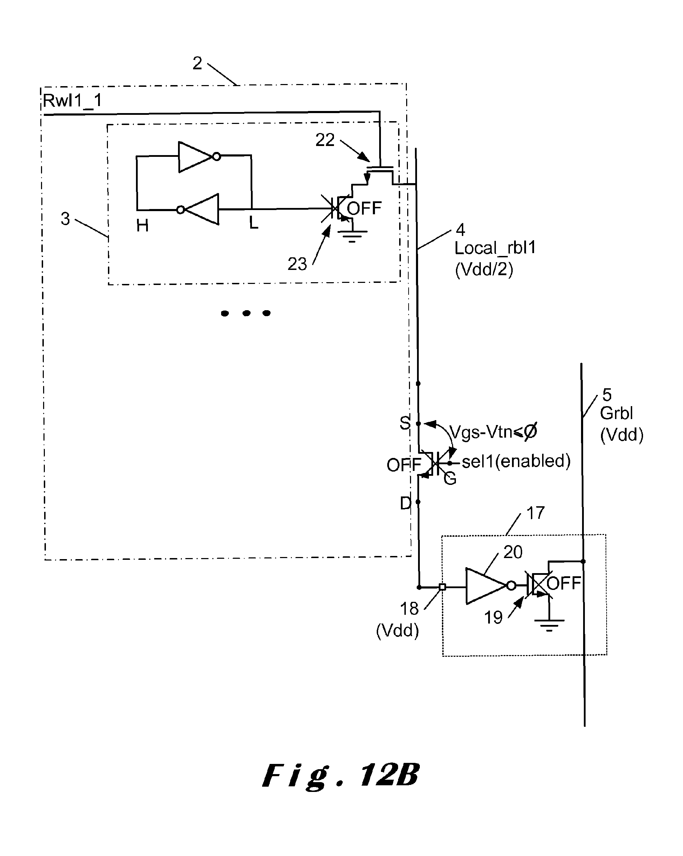

Then the segment buffer 16 is enabled by holding sel1 high, as shown in Fig 12B. As the overdrive of the segment buffer 16 is either zero or negative: Vgs - Vt = (Vsel1 - VDDlow (e.g. VDD/2)) - Vt ≤ 0, the segment buffer 16 is OFF, and the potential of the input node 18 of the inverter 20 remains at its precharge value VDD, thus the global access transistor 19 remains OFF, and the global bit-line Grbl, 5 remains at its pre-charged value (VDD), indicating that the content of the memory cell 3 was low (logic "0").

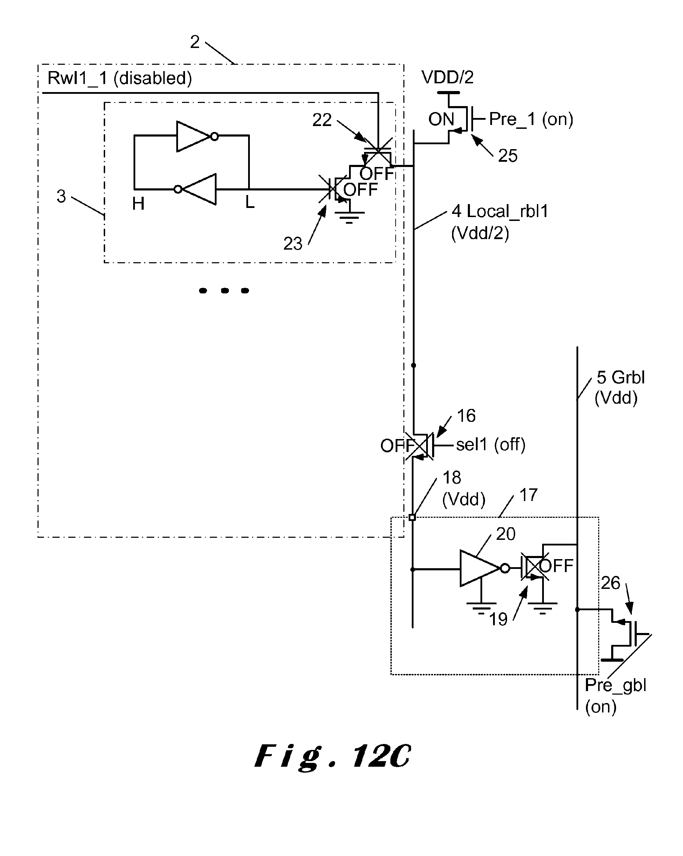

In Fig 12C the restoration of the pre-charge values is shown. The segment buffer 16 is turned OFF by holding sel1 low, all read-word-lines of the memory-block 2 are held low, thus all transistors 22 are OFF, thereby isolating the local bit-line 4 from the SRAM cells 3 and from the inverter input node 18. Then the local bit-line 4 is pre-charged to VDDlow (e.g. VDD/2) by holding pre_1 of transistor 25 high. The input 18 of the inverter 20 is pre-charged to VDD by enabling transistor 24 (see Fig 7). The global bit-line 5 is pre-charged to VDD by enabling transistor 26. Finally all pre-charge transistors 24, 25, 26 are disabled, and the circuit is back in the state of Fig 12A.

Figures 13A-13C show in detail how the circuit diagram of Fig 7 works for a read-operation of a logic "1" stored in the SRAM cell 3. Only one bit-line of the SRAM cell is drawn, the behaviour of the complementary stored value during the read-operation is illustrated in Figures 12A-12C, and vice versa.

In Fig 13A, a logic "High" value is stored on one side (right) of the SRAM-cell 3, and a logic "Low" value is stored on the other side (left) of the SRAM cell 3. The pass-transistor 23a is ON because of the High value stored in the SRAM cell 3. The write_word-line Wwl1_1 is held low during the entire read cycle. The segment buffer 16 is OFF by holding sel1 low. The global bit-line 5 Grbl is pre-charged to VDD, the local bit-line 3 is pre-charged to VDDlow (e.g. VDD/2), the input 18 of the inverter 20 of the read-buffer 17 is pre-charged to VDD, thus the output of the inverter 20 is low and the global access transistor 19 is OFF. For sensing the value stored in the SRAM cell 3, the read word-line Rwl1_1 is enabled (high), thus transistor 22a is ON. In this case, since transistor 23a is also ON, a discharge path to the selected SRAM cell 3a exists, and the pre-charged local bit-line 4 is discharged with a current ICell,read, which is very small due to the minimum sized transistors 22, 23. When reading SRAM cell 3a, the other SRAM cells 3b etc of this local memory block 2 are disabled, thus transistors 22b, etc are OFF.

Then the segment buffer 16 is enabled by holding sel1 high, as shown in Fig 13B. As the overdrive of the segment buffer 16 is positive in this case: Vgs - Vt = Vsel1 - Vt > 0, the segment buffer 16 is ON, and a current Ids will flow through the segment buffer 16, thereby causing a voltage drop in the voltage potential of the input node 18 of the inverter 20, the voltage drop being large enough to switch the state of the inverter 20 and to turn the global access transistor 19 ON, causing the global bit-line Grbl, 5 to be discharged, indicating that the content of the memory cell 3 was high (logic "1 "). By choosing the precharge voltage of the local bit-line 4 substantially smaller than VDD, e.g. VDD/2, the discharge of the local bit-line 4 will happen faster than in the prior art circuits . By choosing the size of the segment transistor 16 larger than the minimum transistor size allowed by the technology used, e.g. 50% or 100% larger, or more, the current Ids is larger (e.g. 3x larger) than the current ICell,read, thus the voltage of the input node 18 of the inverter 20 will drop faster, thus the global access transistor 19 will be activated sooner, resulting in a further reduction of the access time TAccess. Preferably also the size of the global access transistor 19 is chosen larger than the minimum transistor size allowed by the technology used, e.g. 50% or 100% larger, or more, for creating a large discharge current Igrbl_discharge for discharging the global bit-lines 5, resulting in a further reduction of the access time TAccess. The person skilled in the art can find a suitable trade-off between the size of the segment transistor 16 and the size of the global access transistor 19, the reduction in access time TAccess, and the increase in chip area. In one embodiment the size of the segment transistor 16 and the size of the global access transistor 19 are both 2x the size of the transistors used in the SRAM cells (W = 2x Wmin, L = Lmin), but other sizes are possible, e.g. the segment transistor 16 may be 2x larger and the global access transistor 3x larger than the size of the transistors used in the SRAM cells, or vice versa, but other combinations are also possible.

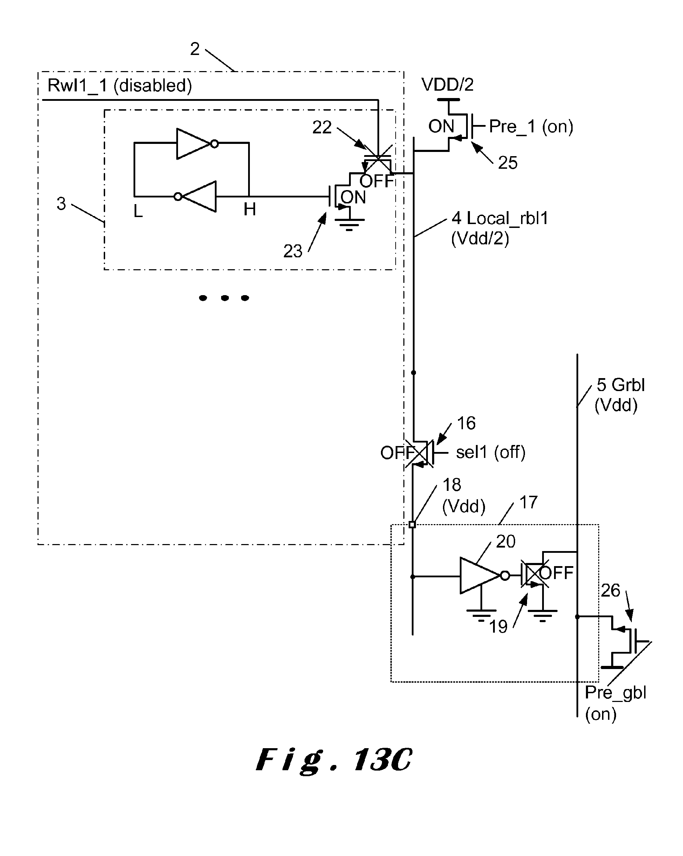

In Fig 13C the restoration of the pre-charge values is shown. The segment buffer 16 is turned OFF by holding sel1 low, all read-word-lines of the memory-block 2 are held low, thus all transistors 22 are OFF, thereby isolating the local bit-line 4 from the SRAM cells 3 and from the inverter input node 18. Then the local bit-line 4 is pre-charged to VDDlow (e.g. VDD/2) by holding pre_1 of transistor 25 high. The input 18 of the inverter 20 is pre-charged to VDD by enabling transistor 24 (see Fig 7), thereby turning the global access transistor 19 OFF for isolating the global bit-line 5, and the global bit-line 5 is pre-charged to VDD by enabling transistor 26. Finally all pre-charge transistors 24, 25, 26 are disabled, and the circuit is back in the state of Fig 13A.

The timing diagram of Fig 8 will be explained. During an idle state the local bit-lines 4 are pre-charged to VDDlow (e.g. VDD/2), and the input node 18 (In) of the pre-charged read buffer 17 is held high (VDD), so that the global access transistor 19 is kept OFF, and the global bit-line GRBL remains high (VDD). When reading the memory cell 3, the read-word-line Rwl1_1 of the selected cell goes high, whereafter the voltage of the local bit-line 4 Local_rbl1 starts to drop, see also Fig 13A. In a following stage, (see also Fig 13B), the control input Trig_S.buffer (called "sel1" in Figures 12A-13C) of the segment buffer 16 goes high, causing a current Ids to flow through the segment buffer 16 for discharging the input node 18, In of the read buffer. Note that the voltage drop of the input node 18 (slope of signal "In") is steeper than the voltage drop of the local bit-line 4 (slope of the signal "Local_rbl1"), due to the larger sized segment transistor 16 as compared to the pass transistors 22, 23.

At the bottom of Fig 8, the voltage drop of the input node 18 is shown in more detail, in full line for the HBS-architecture, in dotted line for the full-swing HDBL-architecture. As can be seen, the voltage on the input node "In" drops rather slowly in the HDBL-architecture, because the input node 18 of the readout buffer 17 is discharged by the minimum sized transistors of the SRAM cell 3, while the voltage of the input node "In" in the HBS-architecture of the present invention drops much faster because of the bigger sized segment transistor 16. T1 is the timing instance when read buffer gets triggered with this solution. T2 is the timing instance when read buffer gets triggered with the existing solution (prior art). Vtrip is the switching point of the read buffer.

Summarizing, the present invention describes a Hierarchical Buffered Segmented bit-line (HBS) architecture

# EP 2 387 039 A1

for a SRAM with a reduced access time (TAccess) and reduced active power consumption (EAccess). A HBS-architecture based SRAM may be attractive as embedded memory for systems on chip (SoCs) e.g. as L1 cache. It solves the technology scaling issues associated with SRAM design in the advance sub-nanometric technologies (e.g. 65 nm LP CMOS technology and beyond) viz. access time degradation and increased power consumption. The main advantages of the architecture is that the energy consumption is reduced by pre-charging the bit-lines to VDDlow, e.g. VDD/2, because the segmentation is done by the segment buffers 16, and that the access speed is increased by the use of segment buffers 16 driving the pre-charged read buffers 17. A 256 kbit HBS based SRAM design in 65 nm LP technology achieves 6,2x times faster access speed as compared to traditional SRAM design in which no bit-line hierarchy is used. And the access speed compared to the existing solutions described in [4] and [5] is not only 1.56x faster but also the energy consumption is 55% less. Thus, with the HBS architecture of the present invention, the access speed is improved and the energy consumption is reduced.

REFERENCES

[1] M.J. Pelgrom , A.C.J. Duinmaijer, and A.P.G.Welbers, "Matching properties of MOS transistors," IEEE J.Solid-State Circuits, Vol. 24, no.5 , pp 1433-1440, Oct 1989.

[2] B.S. Amrutur and M.Horowitz, "Techniques to reduce power in fast wide memories [CMOS SRAMs]" , In Digest of Technical Papers IEEE Symposium Low Power Electronics, pages 92-93, 1994.

[3] "A 3.6pJ/Access 480MHz , 128 kb On-Chip SRAM With 850 MHz Boost Mode in 90 nm CMOS With Tunable Sense Amplifiers" , IEEE JSSC, Vol 44, July 2009, S.Cosemans et al.

[4] A.Karandikar and K.K.Parhi, " Low power SRAM design using hierarchical divided bit-line approach," in Proc.Int.Conf.Computer Design VLSI in Computers and Processors, 1998, pp. 82-88.

[5] "A 45nm 2-port 8T-SRAM Using Hierarchical Replica Bit-line Technique With Immunity From Simultaneous R/W Access Issues", IEEE JSSC , Vol 43, April 2008, S.Ishikura etal.

[6] "An 8T-SRAM for Variability Tolerance and Low-Voltage Operation in High-Performance Caches", IEEE JSSC, Vol43, April 2008, L.Chang etal.

**Claims**

1. A semiconductor memory device (1) comprising:

   - a plurality of memory blocks (2), each memory block comprising a plurality of memory cells (3) connected to a local bit-line (4a, 4b) via at least one switch (22, 23) per memory cell (3), each local bit-line (4a, 4b) being connectable to a global bit-line (5) for memory readout;
   - pre-charging circuitry (24, 25, 26) for pre-charging the local and global bit-lines during an idle state;
   - at least one read buffer (17) connected between at least one of the local bit-lines (4a, 4b) and the global bit-line (5) and being provided for discharging the pre-charged global bit-line (5) during a read operation upon occurrence of a discharge of one of the pre-charged local bit-lines (4a, 4b) connected thereto;

   **characterised in that** the pre-charging circuitry comprises a first pre-charging circuit (25) for pre-charging the local bit-lines (4a, 4b) to a predetermined first voltage during said idle state, said predetermined first voltage being substantially lower than the supply voltage (VDD) of the memory device (1);
   and **in that** a segment buffer (16) is provided between each local bit-line (4a, 4b) and an input node (18) of the respective read buffer (17), the segment buffer (16) being provided for activating said read buffer (17) during said read operation upon occurrence of said discharge on the respective local bit-line.

2. The semiconductor memory device (1) according to claim 1, **characterised in that** the predetermined first voltage to which the local bit-lines (4a, 4b) are pre-charged during the idle state is above a predetermined minimum and that the segment buffer is adapted to not activate the read buffer during said read operation as long as the voltage on said respective local bit-line is above said minimum.

3. The semiconductor memory device (1) according to claim 1 or 2, **characterised in that** the predetermined first voltage is substantially equal to 50% of the supply voltage (VDD).

4. The semiconductor memory device (1) according to any one of the claims 1-3, **characterised in that** the pre-charging circuitry further comprises a second pre-charging circuit (24) for pre-charging the input node (18) of the read buffer (17) to a second voltage above the first voltage and that the segment buffer (16) is adapted for causing a voltage drop on said input node (18) to activate the read buffer (17).

5. The semiconductor device according to claim 4, **characterised in that** the second voltage is substantially equal to the supply voltage.

6. The semiconductor memory device (1) according to any one of the preceding claims, **characterised in that** the local bit-line (4) is connected to ground via a first and a second pass transistor (22, 23) connected in series, the first pass transistor (23) being controlled by the value stored in the memory cell (3), the second pass transistor (22) being controlled by a read-word-line.

7. The semiconductor memory device (1) according to any one of the preceding claims, **characterised in that** the segment buffer (16) comprises an NMOS transistor which is upsized with respect to the transistors used in the memory cells, preferably having a size at least 50% larger than that of the memory cell transistors, more preferably at least 100% larger than that of the memory cell transistors.

8. The semiconductor memory device (1) according to any one of the preceding claims, **characterised in that** the read buffer (17) comprises a global access transistor (19) driven by an inverter (20).

9. The semiconductor memory device (1) according to claim 8, **characterised in that** the global access transistor (19) comprises an NMOS transistor which is upsized with respect to the transistors used in the memory cells, preferably having a size at least 50% larger than that of the memory cell transistors, more preferably at least 100% larger than that of the memory cell transistors.

10. The semiconductor memory device (1) according to any one of the preceding claims, **characterised in that** the input node (18) of the read buffer (17) is connected to at least two memory blocks (2a, 2b), each having a corresponding segment buffer (16a, 16b).

11. The semiconductor memory device (1) according to any one of the preceding claims, **characterised in that** the memory device (1) is a static random access memory (SRAM) device.

12. The semiconductor memory device (1) according to any one of the preceding claims, **characterised in that** the device further comprises control logic for controlling the pre-charging circuitry (24, 25, 26), the at least one read buffer (17) and the segment buffers (16) according to a timing diagram defining said idle state and said read operation, wherein
in said idle state the local bit-lines (4a, 4b) are pre-charged to said predetermined first voltage, the global bit-line (5) and the input nodes (18) of the read buffers (17) are pre-charged to the supply voltage, and the segment buffers (16) are made inactive for isolating the local bit-lines from the input nodes (18);
in said read operation one of the memory cells (3) is sensed by enabling the respective at least one switch (22, 23), causing said discharge of the respective local bit-line (4) depending on the value stored in the memory cell, and subsequently activating the respective segment buffer (16), causing discharge of the input node (18) and activation of the read buffer (17).

13. An electrical device comprising the semiconductor memory device (1) according to any one of the preceding claims.

**Fig. 1**

*Fig.2*

Access Speed Versus VDD

**Fig. 3**

TAccess versus Number of Cells in
Local Hierarchy

*F i g . 4A*

EAccess versus Number of Cells in
Local Hierarchy

*F i g . 4B*

# Fig. 5

*Fig. 6*

*Fig.7*

Pre-charge_rbl1

Pre_R.buffer

Rwl1_1

In

Local_rbl1
(VDD/2)

Trig_S.buffer

GRBL

Vdiff (for Sense Amplifiers)

Speed up T2-T1

Voltage

T1 T2

In

rbl1 (full swing RD BL)

rbl1

Vtrip (RD Buffer)

Time

*Fig. 8*

Access Speed Versus VDD
65nm LP

**Fig. 9**

Access Speed Versus VDD
65nm LP

**Fig. 10**

**Access Energy Versus VDD 65nm LP**

*Fig. 11*

**Fig. 12A**

2

Rwl1_1

22

3

H          L

OFF

23

4
Local_rbl1
(Vdd/2)

5
Grbl
(Vdd)

S

Vgs-Vtn<∅

OFF        sel1(enabled)

G

D

17

20

OFF

18        19

(Vdd)

*F i g . 12B*

*Fig. 12C*

2

3a

Rwl1_1 (enabled)

Wwl1_1 (low)

22a

ON

ON llcell, read

L          H

23a

4

16 cells

Local_rbl1
(Vdd/2 pre-charged)

3b

5
Grbl
(Vdd pre-charged)

22b

OFF

OFF sel1 (disabled)

16

18

(Vdd pre-charged)

20

OFF

19

17

sel2 (disabled)

wbl1                    wblbar1

*Fig. 13A*

**Fig. 13B**

*F i g . 13C*

EP 2 387 039 A1

Europäisches
Patentamt
European
Patent Office
Office européen
des brevets

# EUROPEAN SEARCH REPORT

Application Number

EP 11 16 5741

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 687 175 B1 (MIZUNO HIROYUKI [JP] ET AL) 3 February 2004 (2004-02-03) | 1-5 | INV. G11C11/419 G11C7/18 G11C7/12 |
| Y | * column 10, line 5065; figures 7, 15 * * column 15, line 58 - line 65 * ----- | 6-10 | |
| X | US 2010/054011 A1 (KIM JUHAN [US]) 4 March 2010 (2010-03-04) | 1 | |
| A | * paragraphs [0039], [0 84]; claim 10; figures 2A, 4B * ----- | 6 | |
| Y,D | COSEMANS S ET AL: "A 3.6 pJ/Access 480 MHz, 128 kb On-Chip SRAM With 850 MHz Boost Mode in 90 nm CMOS With Tunable Sense Amplifiers", IEEE JOURNAL OF SOLID-STATE CIRCUITS, IEEE SERVICE CENTER, PISCATAWAY, NJ, USA, vol. 44, no. 7, 1 July 2009 (2009-07-01), pages 2065-2077, XP011263265, ISSN: 0018-9200, DOI: DOI:10.1109/JSSC.2009.2021925 * figures 5, 16 * ----- | 7-10 | |
| Y,D | ISHIKURA S ET AL: "A 45 nm 2-port 8T-SRAM Using Hierarchical Replica Bitline Technique With Immunity From Simultaneous R/W Access Issues", IEEE JOURNAL OF SOLID-STATE CIRCUITS, IEEE SERVICE CENTER, PISCATAWAY, NJ, USA, vol. 43, no. 4, 1 April 2008 (2008-04-01), pages 938-945, XP011206685, ISSN: 0018-9200 * figure 7 * ----- | 6 | TECHNICAL FIELDS SEARCHED (IPC) G11C |

The present search report has been drawn up for all claims

| Place of search | Date of completion of the search | Examiner |
|---|---|---|
| The Hague | 8 July 2011 | Vidal Verdú, Jorge |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 11 16 5741

This annex lists the patent family members relating to the patent documents cited in the above-mentioned European search report.
The members are as contained in the European Patent Office EDP file on
The European Patent Office is in no way liable for these particulars which are merely given for the purpose of information.

08-07-2011

| Patent document cited in search report | | Publication date | Patent family member(s) | | Publication date |
|---|---|---|---|---|---|
| US 6687175 | B1 | 03-02-2004 | AU | 2458700 A | 14-08-2001 |
| | | | WO | 0157875 A1 | 09-08-2001 |
| | | | TW | 476157 B | 11-02-2002 |
| | | | US | 2009027984 A1 | 29-01-2009 |
| | | | US | 2010309741 A1 | 09-12-2010 |
| US 2010054011 | A1 | 04-03-2010 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5668761 A

### Non-patent literature cited in the description

- **M.J. PELGROM ; A.C.J. DUINMAIJER ; A.P.G.WELBERS.** Matching properties of MOS transistors. *IEEE J.Solid-State Circuits,* October 1989, vol. 24 (5), 1433-1440
- **B.S. AMRUTUR ; M.HOROWITZ.** Techniques to reduce power in fast wide memories [CMOS SRAMs. *Digest of Technical Papers IEEE Symposium Low Power Electronics,* 1994, 92-93
- **S.COSEMANS.** A 3.6pJ/Access 480MHz , 128 kb On-Chip SRAM With 850 MHz Boost Mode in 90 nm CMOS With Tunable Sense Amplifiers. *IEEE JSSC,* July 2009, vol. 44
- **A.KARANDIKAR ; K.K.PARHI.** Low power SRAM design using hierarchical divided bit-line approach. *Proc.Int.Conf.Computer Design VLSI in Computers and Processors,* 1998, 82-88
- **S.ISHIKURA.** A 45nm 2-port 8T-SRAM Using Hierarchical Replica Bit-line Technique With Immunity From Simultaneous R/W Access Issues. *IEEE JSSC,* April 2008, vol. 43
- **L.CHANG.** An 8T-SRAM for Variability Tolerance and Low-Voltage Operation in High-Performance Caches. *IEEE JSSC,* April 2008, vol. 43